# EUROPÄISCHE PATENTANMELDUNG

(11) **EP 1 164 638 A2**
(43) Veröffentlichungstag der Anmeldung: **19.12.2001**
(21) Anmeldenummer: 01111880.9
(22) Anmeldetag: 16.05.2001
(51) Int. Cl.: H01L 21/8242

(54) **Verfahren zur Erhöhung Kapazität von Grabenkondensatoren**

(30) Priorität: 13.06.2000 DE 10029036
(71) Anmelder: Infineon Technologies AG, 81669 München (DE)
(72) Erfinder: Morhard, Klaus-Dieter, Dr., 01099 Dresden (DE); Sperl, Irene, 01109 Dresden (DE); Penner, Klaus, 01458 Ottendorf-Okrilla (DE)
(74) Vertreter: Epping Hermann & Fischer

(57) **Zusammenfassung**

Die Erfindung betrifft ein Verfahren zur Erhöhung der Trenchkapazität bei Deep Trench Kondensatoren, bei dem beim Standardverfahren nach der Ätzung des Arsenglases zusätzlich eine nasschemische Ätzung vorgenommen wird, wobei das durch das Austreiben des Arsenglases entstandene n⁺-dotierte Substrat im Trench selektiv sowohl zum niedrig dotierten Substrat als auch zur Oxid- und zur Nitridschicht um etwa 20 nm aufgeweitet wird.

## Beschreibung

Die Erfindung betrifft ein Verfahren zur Erhöhung der Trenchkapazität bei Deep Trench Kondensatoren als Speicherelemente in Halbleiterbauelementen, mit einer in die Tiefe des Wafers reichenden flaschenförmigen Aufweitung, wobei sich auf dem Siliziumsubstrat eine Oxidschicht und auf dieser eine Nitridschicht befinden und in denen durch vorgelagerte fotolithografische Schritte eine Hard Maske ausgebildet ist, deren Öffnungen die Position des auszubildenden Trenches bestimmen, wobei das Silizium anschließend bis in eine erste Tiefe geätzt wird, um einen Trench auszubilden und nachfolgend eine konforme Arsenglas-Abscheidung im Trench vorgenommen wird und anschließend die Schritte des Füllens des Trenches mit Fotolack, des Ätzens des Fotolackes bis in eine zweite, geringere Tiefe, des Ätzens des Arsenglases selektiv zum Fotolack, des Veraschens des verbliebenen Fotolackes im Trench, des Austreibens des Arsens aus dem Arsenglas in das umgebende Substrat, so dass ein n⁺-dotiertes Substrat entsteht, sowie der Ätzung des Arsenglases und der Abscheidung des Nodedielektrikums im Trench und des Abscheidens des n⁺-Poly-Siliziums, ausgeführt werden.

Speicherelemente werden üblicherweise als Kondensatoren ausgeführt, mit denen es möglich ist, besonders geringe Strukturgrößen zu realisieren. Solche Kondensatoren müssen jedoch verschiedene Anforderungen erfüllen. Dies sind neben einer ausreichenden Kapazität insbesondere auch die Fähigkeit der Langzeitspeicherung der Informationen, d.h die Retention Time soll möglichst groß sein. Es muß also sichergestellt sein, dass möglichst keine oder geringe Leckströme zu benachbarten Halbleiterstrukturen fließen. Aus neueren Veröffentlichungen ist bekannt geworden, solche Speicherzellen als Deep Trench Kondensatoren auszuführen. Derartige Kondensatoren besitzen eine relativ geringe Kapazität, die mit weiter sinkender Strukturbreite ebenfalls reduziert wird. Die geringere Kapazität verschärft jedoch die bereits genannten Probleme, indem insbesondere die Retention Time, d.h. die Ladungserhaltungszeit, geringer wird.

Es hat sich jedoch bei der DRAM Entwicklung gezeigt, dass jede Strukturverkleinerung (Shrink) auch zu einer Verschlechterung der Rention Time führt. Die Anforderungen an das Produkt bleiben jedoch gleich. Die bisher einzige praktisch angewandte Möglichkeit zur Lösung dieses Problems besteht darin, die Trenchkapazität zu erhöhen. Hierzu wurde von der Möglichkeit der Verwendung eines dünneren Nodedielektrikums Gebrauch gemacht. Allerdings zeigen sich hier deutliche Grenzen, die durch den Leckstrom durch das Dielektrikum limitiert werden.

Bessere Ergebnisse sind erreichbar, wenn derartige Deep Trench Kondensatoren mit einer in die Tiefe des Wafers reichenden flaschenförmigen Aufweitung versehen werden. Dadurch wird eine deutliche Vergrößerung der Kondensatorfläche und somit eine Erhöhung der Kapazität erreicht. Allerdings ist die Realisierung einer derartigen flaschenförmigen Aufweitung relativ kompliziert, zumal gleichzeitig sichergestellt werden muß, dass zu benachbarten Speicherzellen keine Kurzschlüsse entstehen können, bzw. dass die Isolation zu benachbarten Strukturen noch ausreichend ist, um die Leckströme in Grenzen zu halten.

Die Herstellung derartiger Bottle Deep Trench Kondensatoren kann entweder durch Trocken- oder Naßätzprozesse mit nachfolgendem Auffüllen der geätzten Vertiefung und Aufweitung mit einem Nodedielektrikum erfolgen.

Ein Beispiel eines solchen Kondensators geht aus der US 58 91 807 hervor. Hierbei wird zunächst eine Ätzmaske durch Belichten und Entwickeln eines Resists erzeugt, deren Struktur anschließend durch Trockenätzen, wie reaktives Ionenätzen, Plasmaätzen usw., in eine TEOS und eine darunterliegende Nitridschicht übertragen wird, wodurch eine Hard-Maske entsteht. Anschließend wird der flaschenförmige Trench durch anisotropes reaktives Ionenätzen in zwei Schritten hergestellt. D.h. zunächst wird ein oberer Bereich mit einer leicht abgeschrägten Wandung und im zweiten Schritt die flaschenförmige Aufweitung in die Tiefe realisiert. Dabei werden für beide Ätzschritte durch reaktives Ionenätzen unterschiedliche Rezepturen bzw. Ätzparameter eingesetzt. Beispielsweise kann der zweite Ätzschritt mit den gleichen Ätzgasen, aber anderer Oberflächentemperatur des Wafers oder Verringerung des Druckes innerhalb der Ätzkammer ausgeführt werden.

Problematisch ist in jedem Fall die genaue Parameterbestimmung und insbesondere die Festlegung von Ätzstopparametern, um das Überschreiten der vorgegebenen Ätztiefen sicherzustellen. Auch ist es schwierig, den Zeitpunkt zu bestimmen wann die flaschenförmige Aufweitung beendet werden muß.

Wenn der zweite Ätzschritt zu früh gestoppt wird, wird keine ausreichende Kapazitätsvergrößerung erreicht. Wird der zweite Ätzschritt zu spät gestoppt, besteht die Gefahr, dass zu benachbarten Trenches oder aktiven Gebieten keine ausreichende Isolation mehr vorhanden ist, so dass mit einer Vergrößerung der Leckströme gerechnet werden muß.

Außerdem hat sich gezeigt, dass bei der Anwendung von Trokkenätzprozessen mit einem erhöhten Ausfall einzelner Speicherzellen gerechnet werden muß.

Der übliche Standardprozeß zur Herstellung eines Deep-Trench-Kondensators umfaßt nach der Herstellung der Hard-Maske die Arbeitsschritte, dass das Silizium bis in eine Tiefe von 8 *µ*m geätzt wird, um einen Trench auszubilden und nachfolgend eine konforme Arsenglas-Abscheidung im Trench vorgenommen wird. Anschließend wird der Trench mit Fotolack gefüllt und der Fotolack bis in eine Tiefe von 2*µ*m geätzt. Das Arsenglases wird anschließend selektiv zum Fotolack geätzt und der verbliebenen Fotolackes im Trench Verascht. Zur Erzeugung eines n⁺ dotierten Substrates wird das Arsen aus dem Arsenglas in das umgebende Substrat ausgetrieben und das Arsenglas im Trench durch Ätzen entfernt. Zum Schluß wird der Deep-Trench-Kondensator durch Abscheidung des Nodedielektrikums im Trench und des Abscheidens des n⁺-Poly-Siliziums fertiggestellt.

Der Erfindung liegt nunmehr die Aufgabe zugrunde, ein Verfahren zur Erhöhung der Trenchkapazität zu schaffen, welches sicher zu handhaben ist und mit dem mit geringem Aufwand eine Erhöhung der Trenchkapazität um wenigstens 15 - 20% erreicht werden kann.

Die der Erfindung zugrundeliegende Aufgabenstellung wird bei einem Verfahren der eingangs genannten Art dadurch gelöst, dass nach der Ätzung des Arsenglases eine nasschemische Ätzung vorgenommen wird, wobei das durch das Austreiben des Arsenglases entstandene n⁺-dotierte Substrat selektiv sowohl zum niedrig dotierten Substrat als auch zur Oxid- und zur Nitridschicht aufgeweitet wird.

Mit diesem Verfahren wird einerseits eine wesentlich erhöhte Verfahrenssicherheit erreicht, da durch das selektive Ätzen des n⁺-hochdotierten Bereiches Kurzschlüsse (Shorts) zu benachbarten aktiven Bereichen oder Transistoren sicher vermieden werden und dass andererseits durch das einfach zu realisierende Verfahren eine deutliche Erhöhung der Trenchkapazität um 15 - 20 % erreicht wird.

Vorzugsweise wird für das nasschemische Ätzen eine Polysiliziumätze verwendet, die aus einer Mischung aus konzentrierter Salpetersäure und konzentrierter Flußsäure besteht. Der Trench wird vorzugswiese bis in eine Tiefe von mindestens 8*µ*m geätzt, der Fotolack wird bis in eine Tiefe von mindestens 2*µ*m geätzt und entfernt. Die naßchemische Aufweitung der Trenches erfolgt um etwa 20nm.

Zur weiteren Verbesserung der Selektivität kann der Polysiliziumätze Phosphorsäure und/oder Essigsäure beigemischt werden.

Die Erfindung soll nachfolgend an einem Ausführungsbeispiel mit den wesentlichsten Verfahrenssschritten näher erläutert werden. In den zugehörigen Zeichnungen zeigen:
- Fig. 1: ein mit einer Hard-Maske versehenes Si-Substrat
- Fig. 2: den Trench nach Fig. 1 nach Erreichen der vollständigen Ätztiefe, mit einem im Si-Substrat ausgebildeten n⁺-hochdotierten Bereich; und
- Fig. 3: den fertiggestellten Trenchkondensator mit flaschenförmiger Aufweitung.

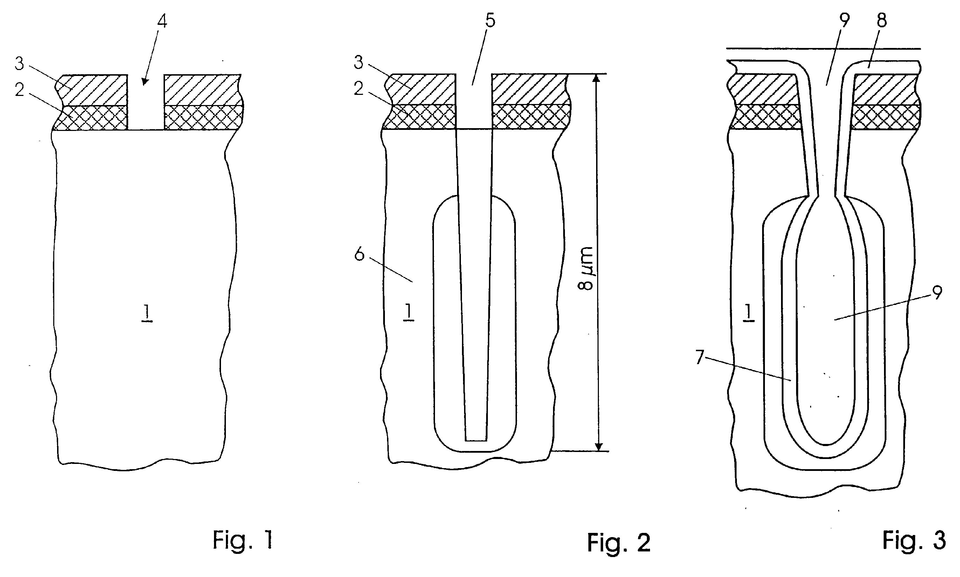

Aus Fig. 1 ist ein Si-Substrat 1 ersichtlich, bei dem in vorbereitenden Schritten eine Oxidschicht 2 und auf dieser eine Nitridschicht 3 aufgebracht worden sind, in denen mittels üblicher Fotolithografie eine sogenannte Hard Maske mit Öffnungen 4 erzeugt worden ist. Diese Öffnungen 4 dienen in den noch zu beschreibenden nachfolgenden Ätzschritten als Ätzmaske. Darüberhinaus können auf dem Si-Substrat weitere Zwischenschichten, z.B. ARC-Schichten, d.h. Antireflexionsschichten, vorhanden sein.

Anschließend kann der Trench 5 bis zu einer Tiefe von ca. 8 *µ*m geöffnet werden, so dass dann im unteren Teil durch Diffusion eine Buried Plate als n⁺-hochdotierter Bereich 6 erzeugt werden kann (Fig. 2). Die Buried Plate 6 kann im Si-Substrat 1 eine Tiefe von 2 *µ*m erreichen.

In einem weiteren Ätzschritt, der jetzt als Nassätzschritt auszuführen ist, kann nun selektiv zur Oxidschicht 2 und zur Nitridschicht 3 in den n⁺-hochdotierten Bereich 6 geätzt werden. Hierzu ist eine Polysiliziumätze, bestehend aus einer Mischung aus konzentrierter Salpetersäure und konzentrierter Flußsäure, geeignet. Eine weitere Verbesserung der Selektivität wird erreicht, wenn der Polysiliziumätze Phosphorsäure und/oder Essigsäure beigemischt wird.

Mit diesem Nassätzschritt wird im unteren Bereich des Trenches 5 eine flaschenförmige Aufweitung 7 um ca. 20 nm erreicht. Dies führt zu der gewünschten Vergrößerung der Kapazität des Trenchkondensators um 15 ... 20 %.

Nach der Ausbildung der flaschenförmigen Aufweitung 7 wird der Trenchkondensator fertiggestellt indem zunächst ein Nodedielektrikum 8 abgeschieden wird, wonach dann der Trench 5 mit einem n⁺-Poly-Silizium 9 aufgefüllt wird.

Bezugszeichenliste
- 1: Si-Substrat
- 2: Oxidschicht
- 3: Nitridschicht
- 4: Öffnung
- 5: Trench
- 6: n+-hochdotierter Bereich
- 7: flaschenförmige Aufweitung
- 8: Nodedielektrikum
- 9: n+-dotiertes Poly-Silizium

## Patentansprüche

1. Verfahren zur Erhöhung der Trenchkapazität bei Deep Trench Kondensatoren als Speicherelemente in Halbleiterbauelementen, mit einer in die Tiefe des Wafers reichenden flaschenförmigen Aufweitung, wobei sich auf dem Siliziumsubstrat eine Oxidschicht und auf dieser eine Nitridschicht befinden und in denen durch vorgelagerte fotolithografische Schritte eine Hard Maske ausgebildet ist, deren Öffnungen die Position des auszubildenden Trenches bestimmen, wobei das Silizium anschließend bis in eine erste Tiefe geätzt wird, um einen Trench auszubilden und nachfolgend eine konforme Arsenglas-Abscheidung im Trench vorgenommen wird und anschließend die Schritte des Füllens des Trenches mit Fotolack, des Ätzens des Fotolackes bis in eine zweite, geringere Tiefe, des Ätzens des Arsenglases selektiv zum Fotolack, des Veraschens des verbliebenen Fotolackes im Trench, des Austreibens des Arsens aus dem Arsenglas in das umgebende Substrat, so dass ein n⁺-dotiertes Substrat entsteht, sowie der Ätzung des Arsenglases und der Abscheidung des Nodedielektrikums im Trench und des Abscheidens des n⁺-Poly-Siliziums ausgeführt werden, **dadurch gekennzeichnet, dass** nach der Ätzung des Arsenglases eine nasschemische Ätzung vorgenommen wird, wobei das durch das Austreiben des Arsenglases entstandene n⁺-dotierte Substrat selektiv sowohl zum niedrig dotierten Substrat als auch zur Oxid- und zur Nitridschicht aufgeweitet wird.

2. Verfahren nach Anspruch 1, **dadurch gekennzeichnet, dass** das nasschemische Ätzen mit einer Polysiliziumätze durchgeführt wird.

3. Verfahren nach Anspruch 2, **dadurch gekennzeichnet, dass** die Polysiliziumätze aus einer Mischung aus konzentrierter Salpetersäure und konzentrierter Flußsäure besteht.

4. Verfahren nach einem der Ansprüche 2 und 3,
**dadurch gekennzeichnet, dass** der Polysiliziumätze Phosphorsäure und/oder Essigsäure beigemischt wird.

5. Verfahren nach einem der Ansprüche 1 bis 4,
**dadurch gekennzeichnet, daß**
die erste Tiefe mindesten 8*µ*m beträgt und die zweite Tiefe mindestens 2*µ*m beträgt.

6. Verfahren nach einem der Ansprüche 1 bis 5,
**dadurch gekennzeichnet, daß**
durch die naßchemische Ätzung das n⁺-dotierte Substrat um etwa 20nm aufgeweitet wird.
